# EUROPÄISCHE PATENTSCHRIFT

(11) **EP 0 757 436 B1**
(45) Veröffentlichungstag und Bekanntmachung des Hinweises auf die Patenterteilung: **08.12.1999**
(21) Anmeldenummer: 95112054.2
(22) Anmeldetag: 29.07.1995
(51) Int. Cl.: H03F 3/72, H03F 3/45

(54) **Schaltungsanordnung mit einem Multiplexer**
Circuit arrangement with a multiplexer
Montage de circuit avec un multiplexeur

(43) Veröffentlichungstag der Anmeldung: 05.02.1997
(73) Patentinhaber: Endress + Hauser Wetzer GmbH + Co. KG, D-87484 Nesselwang (DE)
(72) Erfinder: Becher, Erwin, Dipl.-Ing. (FH), D-87466 Oy-Mittelberg (DE)
(74) Vertreter: Morstadt, Volker, Dipl.-Ing.

(56) Entgegenhaltungen:
- EP-A- 0 051 578
- FR-A- 2 148 774
- US-A- 4 056 686
- US-A- 4 530 365
- US-A- 5 148 121

## Beschreibung

Die Erfindung betrifft eine Schaltungsanordnung zur Durchschaltung von mehreren Signal-Leitungen auf einen Eingang eines Differenzverstärkers mittels eines Multiplexers.

Derartige Schaltungsanordnungen werden z.B. benötigt, wenn Signalkanäle, die Signale führen, die von mehreren Meßstellen mit entsprechenden Sensoren stammen, abwechselnd oder nacheinander auf den Eingang eines Differenzverstärker durchgeschaltet werden sollen. Im allgemeinen hat dabei jeder Signalkanal eine Signal-Leitung und eine Kanalnullpunkt-Leitung. Eine solche Schaltungsanordnung ist z.B. aus US-A-4 056 686 bekannt.

Die Kanalnullpunkt-Leitung braucht nicht unbedingt mit einem zugeordneten Schaltungsnullpunkt verbunden zu sein, wie z.B. im Fall einer Batterie, in dem die Signal-Leitung und die Kanalnullpunkt-Leitung der Verbindung der beiden Pole der Batterie mit gewünschten Stellen einer Schaltung dienen.

Üblicherweise werden mit dem Multiplexer sowohl die Signal-Leitung als auch die Kanalnullpunkt-Leitung zum Differenzverstärker durchgeschaltet; es erfolgt also gemeinhin eine zweipolige Durchschaltung.

Dabei treten jedoch dadurch Probleme auf, daß die einzelnen Kanalnullpunkt-Leitungen Störspannungen aufweisen können, die insb. von der Art und vom Ort des Schaltungsnullpunkts, mit dem die jeweilige Kanalnullpunkt-Leitung verbunden ist, und vom Abstand zwischen diesem Ort und dem Differenzverstärker, also i.a. von der Länge der Kanalnullpunkt-Leitung, abhängen. Die Kanalnullpunkt-Leitungen können aber auch Störströme führen, die zu äquivalenten Störspannungen führen, für die vergleichbare Überlegungen gelten.

Da die Störspannungen von Signalkanal zu Signalkanal außerdem unterschiedliche Amplituden haben können, werden dem Eingang des Differenzverstärkers, auf den die Kanalnullpunkt-Leitungen durchgeschaltet werden, somit von einem Signalkanal zum anderen unterschiedliche Spannungen zugeführt. Daher hat das Ausgangssignal des Differenzverstärkers auch unterschiedliche Störanteile, insb. Nullpunkt-Offsets, und es fließen auf der Eingangsseite des Differenzverstärkers nicht akzeptierbare Ausgleichsströme.

Das geschilderte Problem ist besonders störend, wenn das erwähnte Ausgangssignal des Differenzverstärkers weiterverarbeitet, z.B. mittels eines Anzeige-Geräts, insb. mittels eines Kurvenschreibers, sichtbar gemacht oder registriert, werden soll.

Man hat das Problem schon dadurch zu lösen versucht, daß man den Differenzverstärker und die Signalkanäle galvanisch voneinander getrennt hat, z.B. transformatorisch oder mittels Optokopplern. Dies ist jedoch, insb. bei vielen Signalkanälen, aufwendig.

Zur Lösung der geschilderten Problematik besteht die Erfindung demgegenüber in einer Schaltungsanordnung zur einpoligen Durchschaltung eines von N jeweils eine Signal-Leitung und jeweils eine Kanalnullpunkt-Leitung aufweisenden Signalkanälen, wobei N größer als eins ist, auf einen Eingang eines Verstärkers, dessen Schaltung auf eien diesenm zugeordneten Schaltungsnullpunkt bezogen ist, mittels eines 3N Schaltstrecken aufweisenden Eins-aus-N-Multiplexers, von dem
- ein erster Schaltstrecken-Satz der Durchschaltung der N Signal-Leitungen und
- ein zweiter Schaltstrecken-Satz der Weiterschaltung der N Kanalnullpunkt-Leitungen dient,
- der jeweilige Eingang der Schaltstrecken eines dritten Schaltstrecken-Satzes mit dem jeweiligen Eingang der Schaltstrecken des zweiten Schaltstrecken-Satzes verbunden ist,
- die Ausgänge des zweiten Schaltstrecken-Satzes gemeinsam an einem Eingang eines Hilfsverstärkers und
- die Ausgänge des dritten Schaltstrecken-Satzes gemeinsam am Ausgang des Hilfverstärkers liegen, wobei
   -- dessen Schaltung auf den Schaltungsnullpunkt des Verstärkers bezogen ist.

In Ausgestaltung der Erfindung kann für den Verstärker und den Hilfsverstärker jeweils ein Differenzverstärker eingesetzt werden, von deren Eingängen jeweils einer mit dem Schaltungsnullpunkt des Verstärkers verbunden ist.

Ein Vorteil der Erfindung besteht darin, daß zum Eingang des Verstärkers bzw. des Differenzverstärkers nur noch die Signal-Leitungen durchgeschaltet werden, während die Störspannungen auf den Kanalnullpunkt-Leitungen mittels des Hilfsverstärkers bzw. des Hilfs-Differenzverstärkers kompensiert werden, wobei im Falle des letzteren der andere Eingang des Differenzverstärkers am Schaltungsnullpunkt des Verstärkers liegt. Daher werden auch Störungen zwischen den einzelnen Signalleitungen unterdrückt. Die Erfindung schlägt somit im Gegensatz zur oben erläuterten zweipoligen Durchschaltung eine einpolige Durchschaltung vor.

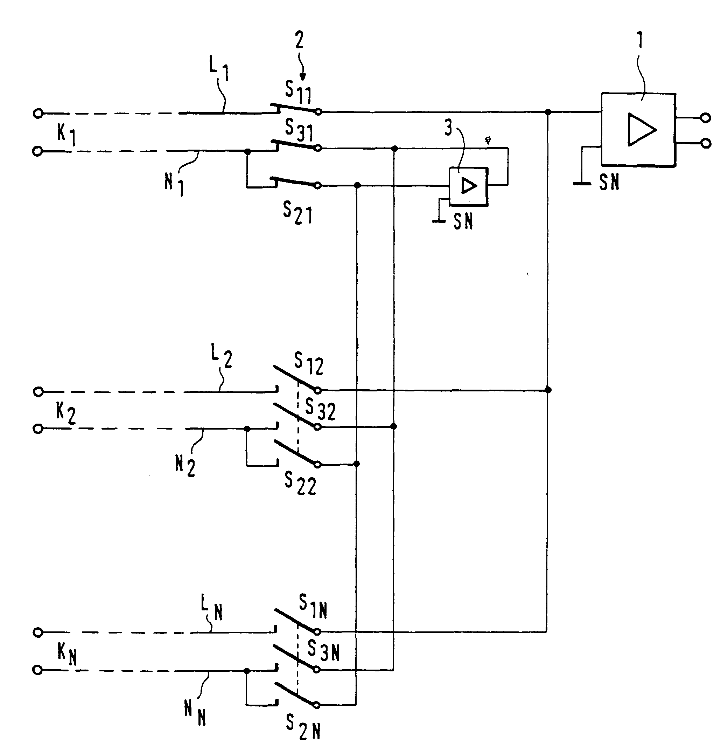

Die Erfindung wird nun anhand der Figur der Zeichnung näher erläutert, in der schematisch nach Art eines Blockschaltbild das der Erfindung zugrundeliegende Prinzip anhand eines Ausführungsbeispiels dargestellt ist.

Von N Signalkanälen, wobei N größer als eins ist, sind in der Figur der Zeichnung drei, nämlich die Signalkanäle K₁, K₂, K_{N}, dargestellt. Jeder von ihnen hat eine jeweilige Signal-Leitung L₁, L₂, L_{N} und eine jeweilige Kanalnullpunkt-Leitung N₁, N₂, N_{N}.

Die Signal- und die Kanalnullpunkt-Leitungen stellen die Verbindung mit einer jeweiligen Signalquelle, z.B. mit einer jeweiligen Meßstelle mit einem entsprechenden physikalisch-elektrischen Wandler, also einem sogenannten Sensor, her. Die Signal- und die Kanalnullpunkt-Leitungen können jeweils beliebig lang sein, was in der Figur durch ihre gestrichelt gezeichneten Teile veranschaulicht sein soll.

Die jeweilige Kanalnullpunkt-Leitung N₁, N₂, N_{N} kann mit einem, z.B. zu der erwähnten Meßstelle gehörenden, eigenen Schaltungsnullpunkt verbunden sein, wie dies eingangs schon erläutert wurde, was aber in der Figur nicht dargestellt ist.

Mittels eines Eins-aus-N-Multiplexers 2 kann jeweils einer der N Signalkanäle K₁, K₂, K_{N} auf einen Verstärker 1 durchgeschaltet werden. Der Eins-aus-N-Multiplexer 2 hat hierzu 3N Schaltstrecken S₁₁, S₂₁, S₃₁, S₁₂, S₂₂, S₃₂, S_{1N}, S_{2N}, S_{3N}, die, zu einem ersten Schaltstrecken-Satz mit den Schaltstrecken S₁₁, S₁₂, S_{1N}, zu einem zweiten Schaltstrecken-Satz mit den Schaltstrecken S₂₁, S₂₂, S_{2N} und zu einem dritten Schaltstrecken-Satz mit den Schaltstrecken S₃₁, S₃₂, S_{3N} gruppiert, gedacht werden können.

In der Figur ist der Eins-aus-N-Multiplexer 2 mittels mechanischer Schalter realisiert dargestellt. Es liegt jedoch im Rahmen der Erfindung, die Schaltstrecken und deren Ansteuerung mittels elektronischen Schaltern, insb. mittels Halbleiter-Schaltern, zu realisieren.

Zur Veranschaulichung der Wirkungsweise des Eins-aus-N-Multiplexers 2 sind in der Figur die dem ersten Signalkanal K₁ zugeordneten Schaltstrecken S₁₁, S₂₁, S₃₁ geschlossen gezeichnet, während die anderen Schaltstrecken der Figur geöffnet gezeichnet sind.

Der erste Schaltstrecken-Satz S₁₁, S₁₂, S_{1N} dient der Durchschaltung der N Signal-Leitungen L₁, L₂, L_{N} zum einen Eingang des Verstärkers 1, dessen Schaltung auf einen diesem zugeordneten Schaltungsnullpunkt SN bezogen ist. Der zweite Schaltstrecken-Satz S₂₁, S₂₂, S_{2N} dient der Weiterschaltung der N Kanalnullpunkt-Leitungen N₁, N₂, N_{N}.

Hierzu ist der jeweilige Eingang der Schaltstrecken S₃₁, S₃₂, S_{3N} des dritten Schaltstrecken-Satzes mit dem jeweiligen Eingang der Schaltstrecken S₂₁, S₂₂, S_{2N} des zweiten Schaltstrecken-Satzes verbunden ist, während dessen Ausgänge gemeinsam an einem Eingang eines Hilfsverstärkers 3 angeschlossen sind. Dessen Schaltung ist ebenfalls auf den Schaltungsnullpunkt SN des Verstärkers 1 bezogen bzw. angeschlossen. Ferner sind die Ausgänge des dritten Schaltstrecken-Satzes S₃₁, S₃₂, S_{3N} gemeinsam am Ausgang des Hilfsverstärkers 3 angeschlossen.

Somit wird einerseits durch den in der Figur ersichtlichen "Kurzschluß" zwischen dem Ausgang des Hilfsverstärkers 3 und dessen Eingang das Potential des Schaltungsnullpunkts SN nach jedem Weiterschalten des Eins-aus-N-Multiplexers 2 an das multiplexer-eingangsseitige Ende der jeweiligen Kanalnullpunkt-Leitung N₁, N₂, N_{N} gelegt.

Somit können die erwähnten Ausgleichsströme und/oder Offsets das Ausgangssignal des Verstärkers 2 nicht nachteilig beeinflussen, und es liegt im Gegensatz zu den eingangs geschilderten zweipoligen Signal-Durchschaltungen auf einen Differenzverstärker nur noch eine einpolige Durchschaltung zum Verstärker 1 vor.

Der Verstärker 1 und der Hilfsverstärker 3 sind in der Figur der Zeichnung jeweils als Differenzverstärker gezeichnet, welche Realisierung bevorzugt wird.

Wie oben schon kurz erwähnt wurde, kann das am Ausgang des Verstärkers 1 auftretende Signal mittels einer Anzeige-Anordnung, z.B. einem Kurvenschreibgerät oder einem Flüssigkristall-Display, in analoger oder in digitaler Form festgehalten und/oder sichtbar gemacht werden. Der Gegenstand der Erfindung ist also bevorzugt Teil solcher Anzeige-Anordnungen.Im Fall der digitalen Registrierung bzw. Anzeige ist dem Verstärker 1 ein Analog/Digital-Wandler nachzuordnen.

## Patentansprüche

1. Schaltungsanordnung zur einpoligen Durchschaltung eines von N jeweils eine Signal-Leitung (L₁, L₂, L_{N}) und jeweils eine Kanalnullpunkt-Leitung (N₁, N₂, N_{N}) aufweisenden Signalkanälen (K₁, K₂, K_{N}), wobei N größer als eins ist, auf einen Eingang eines Verstärkers (1), dessen Schaltung auf einen diesem zugeordneten Schaltungsnullpunkt (SN) bezogen ist, mittels eines 3N Schaltstrecken (S₁₁, S₂₁, S₃₁, S₁₂, S₂₂, S₃₂, S_{1N}, S_{2N}, S_{3N}), aufweisenden Eins-aus-N-Multiplexers (2), von dem
- ein erster Schaltstrecken-Satz (S₁₁, S₁₂, S_{1N}) der Durchschaltung der N Signal-Leitungen (L₁, L₂, L_{N}) und
- ein zweiter Schaltstrecken-Satz (S₂₁, S₂₂, S_{2N}) der Weiterschaltung der N Kanalnullpunkt-Leitungen (N₁, N₂, N_{N}) dient,
- der jeweilige Eingang der Schaltstrecken eines dritten Schaltstrecken-Satzes (S₃₁, S₃₂, S_{3N}) mit dem jeweiligen Eingang der Schaltstrecken des zweiten Schaltstrecken-Satzes (S₂₁, S₂₂, S_{2N}) verbunden ist,
- die Ausgänge des zweiten Schaltstrecken-Satzes (S₂₁, S₂₂, S_{2N}) gemeinsam an einem Eingang eines Hilfsverstärkers (3) und
- die Ausgänge des dritten Schaltstrecken-Satzes (S₃₁, S₃₂, S_{3N}) gemeinsam am Ausgang des Hilfsverstärkers liegen,
-- dessen Schaltung auf den Schaltungsnullpunkt (SN) des Verstärkers (1) bezogen ist.

2. Schaltungsanordnung nach Anspruch 1, bei der als Verstärker (1) und als Hilfsverstärker (3) jeweils ein Differenzverstärker dient, von deren Eingängen jeweils einer mit dem Schaltungsnullpunkt des Verstärkers (1) verbunden ist.

## Claims

1. A circuit arrangement for a single-terminal through-connection of one out of N signal channels (K₁, K₂, K₃) each comprising a signal line (L₁, L₂, L₃) and a channel zero line (N₁, N₂, N₃), where N is greater than one, to an input of an amplifier (1) whose circuit is referenced to an associated ground (SN), using a one-out-of-N multiplexer (2) having 3N switching paths (S₁₁, S₂₁, S₃₁, S₁₂, S₂₂, S₃₂, S_{1N}, S_{2N}, S_{3N}),
- a first switching-path set (S₁₁, S₁₂, S_{1N}) serving to connect through the N signal lines (L₁, L₂, L₃),
- a second switching-path set (S₂₁, S₂₂, S_{2N}) serving to advance the N channel zero lines (N₁, N₂, N₃),
- the respective inputs of the switching paths of a third switching-path set (S₃₁, S₃₂, S_{3N}) being connected to the respective inputs of the switching paths of the second switching-path set (S₂₁, S₂₂, S_{2N}),
- the outputs of the second switching-path set (S₂₁, S₂₂, S_{2N}) being commoned to an input of an auxiliary amplifier (3), and
- the outputs of the third switching-path set (S₃₁, S₃₂, S_{3N}) being commoned to the output of the auxiliary amplifier,
-- whose circuit is referenced to the ground (SN) of the amplifier (1).

2. The circuit arrangement as claimed in claim 1 wherein the amplifier (1) and the auxiliary amplifier (3) are each implemented with a differential amplifier having one of its inputs connected to the ground of the amplifier (1).

## Revendications

1. Circuit destiné à l'interconnexion unipolaire d'un parmi N canaux de transmission de signaux (K₁, K₂, K_{N}) présentant chacun une ligne de transmission de signaux (L₁, L₂, L_{N}) et une ligne de zéro de canal (N₁, N₂, N_{N}), N étant plus grand que un, à l'entrée d'un amplificateur (1) dont le couplage est rapporté à un zéro de couplage (SN) qui lui est associé, au moyen d'un multiplexeur un-sur-N (2) présentant 3N longueurs de coupure (S₁₁, S₂₁, S₃₁, S₁₂, S₂₂, S₃₂, S_{1N}, S_{2N}, S_{3N}), dans lequel
- un premier ensemble de longueurs de coupure (S₁₁, S₁₂, S_{1N}) sert à la connexion des N lignes de transmission de signaux (L₁₁, L₁₂, L_{N}) et
- un deuxième ensemble de longueurs de coupure (S₂₁, S₂₂, S_{2N}) sert à la connexion des N lignes de zéro de canal (N₁₁, N₁₂, N_{N}).
- l'entrée respective des longueurs de coupure d'un troisième ensemble de longueurs de coupure (S₃₁, S₃₂, S_{3N}) est reliée à l'entrée respective des longueurs de coupure du deuxième ensemble de longueurs de coupure (S₂₁, S₂₂, S_{2N}).
- les sorties du deuxième ensemble de longueurs de coupure (S₂₁, S₂₂, S_{2N}) sont réunies à une entrée d'un amplificateur auxiliaire (3) et
- les sorties du troisième ensemble de longueurs de coupure (S₃₁, S₃₂, S_{3N}) sont réunies à la sortie de l'amplificateur différentiel,
- - dont le couplage est rapporté au zéro de couplage (SN) de l'amplificateur (1).

2. Circuit selon la revendication 1, dans lequel un amplificateur différentiel sert respectivement d'amplificateur (1) et d'amplificateur auxiliaire (3), l'une des entrées dudit amplificateur différentiel étant à chaque fois reliée au point de couplage de l'amplificateur (1).
